# EUROPEAN PATENT APPLICATION

(11) **EP 0 540 157 A1**
(43) Date of publication of application: **05.05.1993**
(21) Application number: 92308272.1
(22) Date of filing: 11.09.1992
(51) Int. Cl.: H01L 21/76

(54) **Method for submicron isolation for CMOS devices**

(30) Priority: 30.09.1991 US 769179
(71) Applicant: SGS-THOMSON MICROELECTRONICS, INC., Carrollton Texas 75006 (US)
(72) Inventor: Chen, Fusen E., Milpitas, CA 95129 (US); Liou, Fu-Tai, Carrollton, Texas 75010 (US); Dixit, Girish Anant, Dallas, Texas 75287 (US)
(74) Representative: Palmer, Roger

(57) **Abstract**

According to the present invention, a method for forming field oxide is presented. An oxidation barrier comprising oxide (12) and silicon nitride (16) is formed over a semiconductor substrate. An opening (18) through the oxidation barrier is created to expose a portion of the substrate (10). A field oxide region (20) is formed and then removed. A layer of silicon nitride (22) is then deposited over the device. A portion of the silicon nitride layer (22) is removed to expose an area where a second field oxide region (28) is then formed.

## Description

The present invention relates generally to semiconductor integrated circuits, and more specifically to the formation of field oxide regions in a semiconductor substrate.

One type of structure commonly found on a semiconductor integrated circuit is a transistor. Field effect transistors can be either n-channel or p-channel, and both types of transistors can be formed on one integrated circuit. Field oxide regions are formed to separate the transistors. In this process regions of silicon dioxide are selectively grown on the substrate to provide isolation between dopant wells. As known in the art, transistors will be defined in those areas without field oxide. These areas are known as active regions.

The process of growing field oxide involves depositing and patterning insulation layers which protect the active regions from oxidation. Typically, a thin oxide layer is grown over the substrate, with layers of polycrystalline silicon and silicon nitride deposited thereafter. The purpose of the oxide and polycrystalline silicon layers is to act as a buffer and alleviate the stress created during the manufacturing process between the substrate and the nitride layer. Those skilled in the art will recognize that this stress can create undesirable crystal defects in the substrate.

One problem encountered with integrated circuits is a condition known as latchup. Latchup is caused by parasitic devices which are inherent components of any CMOS device. These parasitic components are formed by the various physical regions which make up the CMOS device.

One technique known in the art which is used to lower the possibility of latchup is the formation of a channel stop region. Another possible solution is to form a field oxide region which extends deeper into the substrate. This has the effect of increasing the threshold voltages of the parasitic components. However, when forming a field oxide region that extends deeper into the substrate, the resulting structure becomes more nonplanar. This undesirable effect makes further processing steps more difficult.

Various techniques are used to reduce the nonplanar effects of deeper oxide formation. One such technique involves the formation of cavities in the substrate before the field oxide is formed. An opening through the insulating layers is created and a layer of the exposed substrate is removed. Sidewall spacers are then formed along the vertical sidewalls of the opening, and another layer of the exposed substrate is removed. See, F. Bryant et al, "Pad Oxide Protect Sealed Interface Isolation Process," U. S. Patent number 4,981,813. This technique, however, does not adequately address all of the concerns discussed above.

Therefore, it would be desirable to provide a technique for forming field oxide regions that are both more planar with the substrate and extend deeper into the substrate, without significantly increasing the complexity of the manufacturing process.

It is therefore an object to the present invention to provide a method for forming field oxide regions which extend deeply into the semiconductor substrate.

It is another object of the present invention to provide a method for forming field oxide regions which have reduced height and are more nearly level with the upper surface of the semiconductor substrate.

It is another object of the present invention to provide such a method and structure which is compatible with standard process flows, and which add minimal additional complexity to the fabrication of a typical integrated circuit.

Therefore, according to the present invention, a method for forming field oxide includes the formation of a first field oxide region in a semiconductor substrate. This field oxide region is isotropically etched away, creating a cavity in the substrate. A relatively thin layer of field oxide may be retained or grown on the substrate. A conformal layer of silicon nitride is then deposited over the device, and a portion of that layer is then anisotropically etched away to expose the cavity in the substrate. The remaining silicon nitride layer acts as an oxidation barrier, and the cavity helps to create a second field oxide region which is more level with the semiconductor substrate. A second region of field oxide is then formed, resulting in the oxide extending deeper into the substrate.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

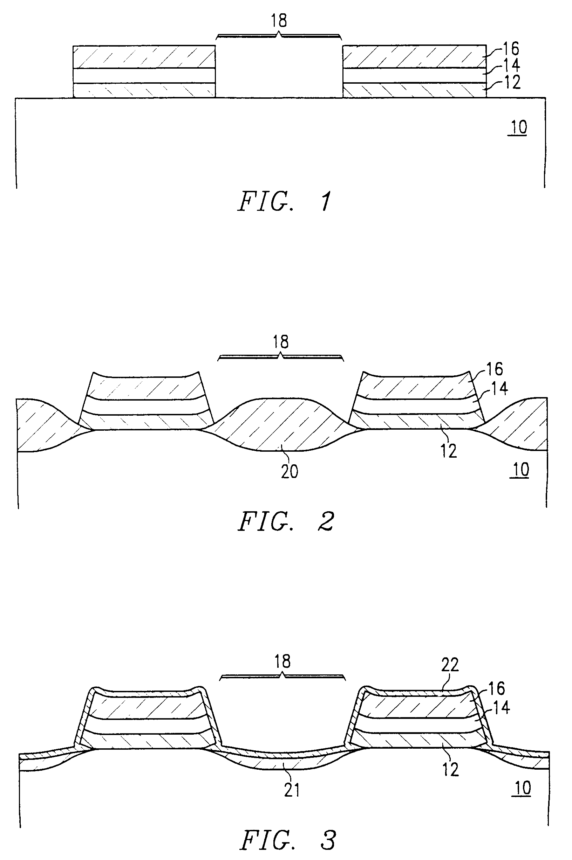

**Figures 1 - 5** illustrate a preferred method of forming field oxide for integrated circuits according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to **Figure 1**, an integrated circuit will be formed in and on a substrate **10**. A thin insulating layer **12** is deposited or grown on the surface of the substrate **10**. A conformal layer **14** of polycrystalline silicon is deposited on the integrated circuit, followed by a protective layer **16**. Using a photoresist layer (not shown) as a mask, an opening **18** is formed by anisotropically etching through the various layers to expose a portion of the substrate **10**.

The protective layer **16** is also conformal to its underlying structures, and is typically made of silicon nitride. Its purpose is to inhibit oxidation. The insulating layer **12** is typically made of oxide, and is often described as a pad layer because it primarily serves to relieve stress between the substrate **10** and the protective layer **16**. This stress relief minimizes crystal defects in the substrate **10**.

**Figure 2** illustrates the integrated circuit after an oxidation step has been performed to grow a first region of silicon dioxide **20**. This region of silicon dioxide **20** is known in the art as field oxide. The field oxide is used to isolate the active regions of transistors created in the substrate **10**.

Referring to **Figure 3**, the first field oxide region is removed by an isotropic etch, and a thin oxide layer **21** is grown in the opening **18**. This helps to fill in the areas under the insulating layer **12** where some of the substrate **10** was removed during the isotropic etch. Alternatively, it is possible to obtain the thin oxide layer **21** by not completely removing the first field oxide region during the isotropic etch. A conformal layer **22** of silicon nitride is then deposited over the device and extends into the opening **18**.

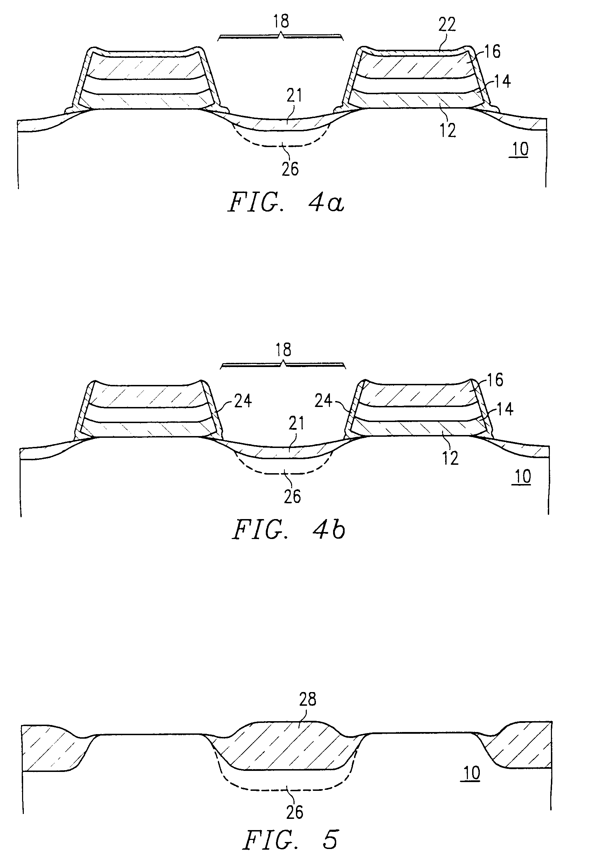

As shown in **Figure 4A**, the conformal layer **22** can be anisotropically etched in order to expose the thin oxide layer **21**. This process is accomplished by using a photoresist layer (not shown) as a mask. An alternative to using a photoresist mask is shown in **Figure 4B**. The conformal layer **22** is anisotropically etched creating sidewall spacers **24** along the vertical sidewalls of the opening **18**.

If a photoresist mask is used to remove a portion of the conformal layer **22**, alignment and size of the mask are not critical. Those skilled in the art will recognize that if the opening in the mask is oversized, the anisotropic etch will create sidewall spacers similar to those shown in **Figure 4B**. If the mask is not properly aligned, the etch can remove some of the conformal layer **22** covering the oxidation barrier and sidewall spacers will be formed in the opening **18**.

Once the conformal layer **22** or sidewall spacers **24** are in place, the layer of silicon dioxide **20** remaining in the substrate **10** will act as a buffer and relieve the stress between the substrate **10** and the conformal layer **22** or sidewall spacers **24**. As one skilled in the art will appreciate, the reduction of stress between the substrate **10** and the conformal layer **22** or sidewall spacers **24** will reduce the number of crystal defects which occur in the substrate **10**.

A second region of silicon dioxide is then grown (not shown). Those skilled in the art will recognize that a channel-stop implant or diffusion **26** can be performed before the second field oxide region is formed. The purpose of the channel-stop **26** is to prevent latchup, which is caused by turning on the parasitic components within the device.

During formation of the second field oxide region **28**, the conformal layer **22** or sidewall spacers **24** inhibits lateral oxidation of the oxide **21** into the active regions of the substrate **10**. Reducing the encroachment of silicon dioxide into the active regions helps in decreasing the size of the bird's beak. The exposed portion of oxide **21** continues to oxidize, causing the field oxide region **28** to extend deeper and further into the substrate **10**.

**Figure 5** illustrates the substrate **10** once the field oxide grown in the opening **18** and the insulating conformal and protective layers are removed. The integrated circuit is now ready for further processing using techniques which are known in the art.

As an example of the preferred embodiment, the following dimensions are used to illustrate the process flow. The insulating layer **12** of oxide may be 130 Å, the conformal layer **14** of polycrystalline silicon 500 Å, and the protective layer **16** of silicon nitride 2500 Å thick. The first field oxide region **20** may reach a thickness in the range of 3000 - 7000 Å. If a layer of this first field oxide region is to be retained, the isotropic etch is used to remove 2000 - 6000 Å of the field oxide. The conformal layer **22** of silicon nitride is deposited over the device, such that a thickness of 1000 Å is obtained. Finally, the second field oxide region **28** is grown to reach a thickness somewhere between 4000 - 8000 Å.

As will be appreciated by those skilled in the art, the techniques described above create field oxide regions which are more nearly level with the semiconductor substrate. Additionally, the field oxide extends deeper or further into the substrate. This provides the added advantage of increasing field threshold voltages of the parasitic components within the integrated circuit.

While the invention has been particularly shown and described with reference to a preferred embodiment, it will be understood by those skilled in the art that various changes in form and detail may be made therein without departing from the spirit and scope of the invention.

## Claims

1. A method for formation of an isolation region, comprising the steps of:
creating an oxidation barrier over a semiconductor substrate;
removing a portion of the oxidation barrier to define an opening where oxide will be grown;
forming a first field oxide region in the opening of said oxidation barrier;
removing said first field oxide region grown in the opening of said oxidation barrier; and
forming a second field oxide region in the opening of said oxidation barrier.

2. The method of Claim 1, wherein a conformal oxidation inhibiting layer is deposited over the oxidation barrier and extending into the opening before the second field oxide region is formed.

3. The method of Claim 2, further comprising the steps of:
depositing and patterning a photoresist layer over said conformal oxidation inhibiting layer; and
anisotropically etching said conformal oxidation inhibiting layer to expose a portion of the semiconductor substrate where the second field oxide region will be formed.

4. The method of Claim 2, further comprising the step of anisotropically etching said conformal oxidation inhibiting layer in order to form sidewall spacers along side the vertical sidewalls of said opening.

5. A method for formation of an isolation region, comprising the steps of:
creating an oxidation barrier over a semiconductor substrate;
removing a portion of the oxidation barrier to define an opening where oxide will be grown;
forming a first field oxide region in the opening in said oxidation barrier;
removing said field oxide region grown in the opening of said oxidation barrier;
depositing a conformal oxidation inhibiting layer over the oxidation barrier and extending into said opening;
removing a portion of said conformal oxidation inhibiting layer to expose a portion of the semiconductor substrate where a second field oxide region will be formed; and
forming a second field oxide region in the opening of said oxidation barrier.

6. The method of Claim 1 or 5 wherein said oxidation barrier includes silicon nitride.

7. The method of Claim 6, wherein said oxidation barrier is a multilayer comprising oxide, polycrystalline silicon, and silicon nitride.

8. The method of Claim 1 or 5 wherein said step of removing a portion of the oxidation barrier comprises anisotropically etching the oxidation barrier.

9. The method of Claim 5, wherein said step of removing the first field oxide region comprises isotropically etching the field oxide region.

10. The method of Claim 5 or 9 wherein a relatively thin layer of oxide is formed on the substrate following removal of said first field oxide region.

11. The method of Claim 10, wherein said step of forming a relatively thin layer of oxide comprises thermally growing said oxide.

12. The method of Claim 1 or 5 wherein said step of removing the first field oxide region comprises removing a portion of the first field oxide region, wherein a relatively thin layer remains on the semiconductor substrate.

13. The method of Claim 5, wherein the step of removing a portion of the conformal oxidation inhibiting layer comprises the steps of:
depositing and patterning a photoresist layer over said conformal oxidation inhibiting layer; and
anisotropically etching said conformal oxidation inhibiting layer to expose a portion of the semiconductor substrate where the second field oxide region will be formed.

14. The method of Claim 5, wherein the step of removing a portion of a conformal oxidation inhibiting layer comprises the step of anisotropically etching said conformal oxidation inhibiting layer in order to form sidewall spacers alongside the vertical sidewalls of the opening.

15. The method of Claim 2 or 5 wherein said conformal oxidation inhibiting layer comprises silicon nitride.

16. The method of Claim 1 or 5 wherein a channel stop region is formed in the semiconductor substrate before the second field oxide region is formed.

17. The method of Claim 16, wherein said step of forming a channel stop region comprises implanting said region into the semiconductor substrate.

18. An isolation region for an integrated circuit comprising:
a semiconductor substrate; and
a field oxide region that is substantially planar with the semiconductor substrate.

19. The isolation region of Claim 18, wherein the field oxide region has a configuration caused by:
forming a first field oxide region in a semiconductor substrate;
removing said first field oxide region; and
forming a second field oxide region in said semiconductor substrate.

20. The isolation region of Claim 19, wherein the field oxide region has a configuration formed by not completely removing the first field oxide region.

21. The isolation region of Claim 19, wherein the field oxide region has a configuration formed by forming a relatively thin layer of oxide on the substrate following the removal of the first field oxide region.

22. The isolation region of Claim 18, wherein the bird's beak area of the field region is located near the upper surface of said field oxide region.
